Europäisches Patentamt

European Patent Office

Office européen des brevets

(11) Veröffentlichungsnummer: **0 471 267 A2**

# (12) EUROPÄISCHE PATENTANMELDUNG

(21) Anmeldenummer: **91113146.4**

(22) Anmeldetag: **05.08.91**

(30) Priorität: **16.08.90 DE 4025980**

(43) Veröffentlichungstag der Anmeldung:
**19.02.92 Patentblatt 92/08**

(84) Benannte Vertragsstaaten:
**DE FR NL**

(51) Int. Cl.⁵: **C09K 11/08, G21K 4/00**

(71) Anmelder: **SIEMENS AKTIENGESELLSCHAFT**
**Wittelsbacherplatz 2**
**W-8000 München 2(DE)**

(72) Erfinder: **Leppert, Jürgen, Dipl.-Ing. (FH)**
**Flurstrasse 8**
**W-8552 Inning a. Holz(DE)**
Erfinder: **Rossner, Wolfgang, Dr.**
**Dekan-Imminger-Strasse 25**
**W-8150 Holzkirchen(DE)**

(54) **Verfahren zum Herstellen einer Leuchtstoffplatte.**

㉝ Das Verfahren, bei dem die Platte durch eine Warmbehandlung aus einem Rohling hergestellt wird, ist gekennzeichnet durch Walzen oder Extrudieren. Eine nach diesem Verfahren hergestellte Platte aus einem Leuchtstoff, insbesondere einem Speicherleuchtstoff, hat praktisch keine innere optische Streuung.

EP 0 471 267 A2

Die Erfindung bezieht sich auf ein Verfahren zum Herstellen einer Leuchtstoffplatte, insbesondere einer Speicherleuchtstoffplatte, durch Warmverformung eines Rohlings bei einer Temperatur unterhalb der Schmelztemperatur.

Bekanntlich können aus Leuchtstoffen Szintillatoren hergestellt werden, in denen eine einfallende Röntgen- oder γ-Strahlung durch Photoeffekt oder Comptoneffekt Elektronen auslöst. Diese Sekundärelektronen geben ihre Energie wieder an den Leuchtstoff ab und regen ihn dadurch zum Leuchten an. In einem nachfolgenden Sekundärelektronenvervielfacher lösen diese Lichtquanten Stromimpulse aus, die einem elektronischen Impulshöhenanalysator zur Sortierung je nach ihrer Höhe Zugeführt werden. Als Leuchtstoff sind vorzugsweise anorganische Verbindungen geeignet, die im allgemeinen durch geringe Zusätze von Fremdstoffen aktiviert sind, beispielsweise mit Thallium aktiviertes Natrium-, Kalium- oder Cäsiumjodid sowie mit Natrium dotiertes Cäsiumjodid oder auch mit Europium aktiviertes Lithiumjodid.

Bei der digitalen Computer-Radiographie wird bekanntlich das Bild einer Röntgendurchstrahlung in einer sogenannten Speicherplatte umgewandelt in elektrische Ladungen und gespeichert. Zu diesem Zweck enthält sie einen Speicherleuchtstoff, der im allgemeinen auf einem Träger, beispielsweise einer Folie, aufgebracht ist. In einer Ausleseeinrichtung wird das flächenhafte Muster verschiedener Röntgenintensitäten umgewandelt in entsprechende elektrische Signale, die über einen Analog-Digital-Wandler einem Bildaufbaurechner zugeführt werden. Nach erneuter Umwandlung in analoge Signale kann das Bild auf einem Bildschirm sichtbar gemacht werden.

In der Ausleseeinrichtung wird der Speicherleuchtstoff angeregt durch energiereiche Lesestrahlen, insbesondere einen roten Laser, und diese photostimulierte Lumineszenz wird punktweise nacheinander jeweils mit Hilfe eines Lichtleiters einem Photomultiplier als Verstärker zugeführt. Der Laserstrahl kann mit Hilfe einer Optik auf der Speicherplatte fokussiert und mit einem Drehspiegel über die Zeile abgelenkt werden. Die Speicherplatte und der Fächer des Laserstrahls werden stufenweise relativ zueinander verschoben und damit das gesamte Bild zeilenweise vom Laserstrahl abgetastet.

Wesentliche Merkmale solcher bildgebenden Systeme sind die Ortsauflösung, der Kontrast, die Bildschärfe, der Signal-Störwert-Abstand und die Modulationsübertragungsfunktion. Diese Merkmale sind wesentlich abhängig von den charakteristischen Eigenschaften des jeweiligen Speicherleuchtstoffes und insbesondere von der optischen Qualität der Leuchtstoffbeschichtung der Speicherplatte. Besondere Bedeutung kommt hierbei der optischen Streuung der Stimulations- und Emissionsstrahlung in der Speicherleuchtstoffschicht zu. Verursacht wird die optische Streuung in solchen Speicherleuchtstoffschichten im wesentlichen durch Poren und sekundäre Materialphasen des Speicherleuchtstoffes. Wird die fokussierte Stimulationsstrahlung beim Durchtritt durch die Speicherleuchtstoffschicht gestreut und das durch die geometrische Optik vorgegebene Stimulationsvolumen überschritten, so wird die registrierte stimulierte Emissionsintensität durch den Beitrag aus dem Streuvolumen der Stimulationsstrahlung verfälscht. Ein geringer Teil der Stimulationsstrahlung kann hierbei das gesamte Speicherleuchtstoffvolumen durchlaufen. Solche Streueffekte nehmen naturgemäß mit wachsender Dicke der Speicherleuchtstoffschicht zu und verschlechtern vorwiegend die Ortsauflösung, den Kontrast und die Modulationsübertragungsfunktion.

Speicherleuchtstoffschirme, deren Speicherschicht beispielsweise aus mit Europium aktiviertem Bariumfluorbromid BaFBr:Eu oder auch aus mit Thallium aktiviertem Rubidiumbromid RbBr:Tl bestehen kann, werden im allgemeinen dadurch hergestellt, daß der pulverförmige Speicherleuchtstoff in einem meist organischen Bindemittel dispergiert und anschließend auf den Träger aufgetragen wird, der im allgemeinen aus einer Kunststoffolie besteht.

Es wurde nun erkannt, daß diese optisch unterschiedlichen Phasen, nämlich des Speicherleuchtstoffes und des Bindemittels, einer inneren optischen Streuung unterliegen, die das ausgelesene Bild wesentlich beeinflussen kann. In einer Speicherleuchtstoffschicht mit einer Dicke von beispielsweise etwa 0,1 bis 0,3 mm wird ein zur Auslesung verwendeter Laserstrahl um etwa das 10fache seiner Eintrittsfokussierung aufgestreut.

Es ist deshalb bekannt, daß ein flacher Formkörper aus Cäsiumjodid CsJ mit einer polierten Flachseite dadurch hergestellt werden kann, daß ein zylindrischer Rohling in einer Matrize heiß geschmiedet wird (SPIE, Vol. 508, Product. Aspects of Single Point Mach. Optics (1984), S. 121 bis 125).

Es ist ferner bekannt, daß ein Leuchtstoff für Röntgen- und γ-Strahlen dadurch hergestellt werden kann, daß der pulverförmige Leuchtstoff, beispielsweise mit Europium aktiviertes Bariumfluorchlorid BaFCl:Eu oder mit Thallium aktiviertes Cäsiumjodid CsJ:Tl, einer Wärmebehandlung unterzogen wird. Die pulverförmige Mischung wird bei erhöhter Temperatur unterhalb der Schmelztemperatur und während einer zur Verdichtung ausreichenden Zeit unter einem hohen Druck bis zu etwa 50 000 kg/cm$^2$ gepreßt. Der so durch gerichtete Verformung hergestellte Barren aus dem Leuchtstoff kann gegebenenfalls anschließend noch bei einer Temperatur unterhalb der Schmelztemperatur geschmiedet werden (DE-OS 28 49 705).

Der Erfindung liegt nun die Aufgabe zugrunde, dieses bekannte Herstellungsverfahren für Leuchtstoffe zu vereinfachen und zu verbessern, insbesondere soll die innere optische Streuung der Leuchtstoffe weiter vermindert werden und es sollen Platten hergestellt werden, die selbsttragend ohne weiteren Träger verwendet werden können. Die Erfindung beruht auf der Erkenntnis, daß die Porosität der bekannten, durch gerichtete Verformung hergestellten Speicherleuchtstoffe immer noch eine innere optische Streuung erzeugt, welche die Eigenschaften des hergestellten Bildes wesentlich beeinflussen kann.

Es kann auch ein plattenförmiger Szintillator dadurch hergestellt werden, daß ein pulverförmiges Szintillatormaterial mit einem Verdichtungszusatz gemischt, in einem Behälter erhitzt und dann unter isostatischem Druck gepreßt wird. Nach dem Abkühlen wird der Sinterkörper aus dem Behälter genommen und zu einer dünnen Platte verarbeitet. Dieser aus der Sinterkörperplatte bestehende Szintillator kann in einen Detektor eingesetzt werden, der mit einer Photodiode eine gemeinsame Baueinheit bildet (DE-OS 36 29 180).

Gemäß der Erfindung wird nun die genannte Aufgabe gelöst mit den kennzeichnenden Merkmalen der Ansprüche 1 und 2. Besonders vorteilhafte weitere Ausgestaltungen ergeben sich aus den Unteransprüchen. Durch das Walzen oder Extrudieren des optisch isotropen, transparenten und streulichtarmen Rohlings aus einem Leuchtstoff oder Speicherleuchtstoff wird eine dünne Platte hergestellt, deren Dicke wenigstens 0,05 mm beträgt und etwa 5 mm nicht wesentlich überschreitet und vorzugsweise etwa 0,1 bis 1 mm, insbesondere etwa 0,2 bis 0,5 mm, betragen kann. Durch den hohen Verformungsgrad von wenigstens etwa 80 % erhält man eine Platte, die gegebenenfalls selbsttragend ohne besonderen Träger verwendet werden kann und deren innere Streuung praktisch vernachlässigbar klein ist.

Der Rohling ist ein transparenter, einschlußfreier polykristalliner oder auch einkristalliner Körper, der als Schmelzblock durch thermisch kontrollierte Abkühlung einer Schmelze oder auch als Kristallblock durch Kristallzüchtung hergestellt werden kann. Für das Verfahren gemäß der Erfindung eignen sich besonders Speicherleuchtstoffe aus der Verbindungsklasse der Alkalihalogenide mit geeigneten Dotierungen, wie beispielsweise Thallium, Silber, Alkalien oder Erdalkalien, sowie Seltene Erden als Einzel- oder Mehrfachdotierung, aufgrund ihres kongruenten Schmelzverhaltens und ihrer hohen Plastizität. Aus mit Thallium aktiviertem Rubidiumjodid können beispielsweise Platten mit einer Größe von beispielsweise etwa 100 x 100 mm und einer Dicke von vorzugsweise etwa 0,1 bis 0,3 mm hergestellt werden, die im allgemeinen mit einem Träger, beispielsweise Glas, versehen werden. Aus mit Thallium aktiviertem Natriumjodid können auch Platten mit einer Größe von beispielsweise 500 x 500 mm und einer Dicke von beispielsweise etwa 2 bis 20 mm, vorzugsweise etwa 3 bis 10 mm, und insbesondere etwa 8 mm hergestellt werden, die freitragend ohne besonderen Träger als Szintillator verwendet werden können.

Bei der Warmverformung durch Walzen wird ein geeigneter Rohling bei Temperaturen zwischen etwa 20 und 600 °C, aber unter der Schmelztemperatur des jeweiligen Speicherleuchtstoffes bei Drücken zwischen 10 und 800 MPa mit Verformungsgraden bis zu etwa 95 % umgeformt. Mit diesem Verfahren können freitragende Speicherleuchtstoffplatten und auch mehrlagige Speicherleuchtstoffschirme hergestellt werden, die auf einem Träger aufgebracht sind. Die Speicherleuchtstoffschichten können gegebenenfalls noch mit optischen Absorptions- und Reflexionsschichten oder auch mit Schutzschichten gegen mechanischem und chemischem Angriff versehen werden.

Bei der Warmverformung durch Extrudieren wird der Rohling in einer Preßmatrize vorgelegt und bei Temperaturen unterhalb der Schmelztemperatur im allgemeinen unter 600 °C mit einem Druck von etwa 100 MPa bis 800 MPa mittels einachsiger Stempelbewegung durch ein Mundstück mit der gewünschten Öffnungsgeometrie ausgepreßt. Mit diesem Verfahren können insbesondere freitragende dünne Speicherleuchtstoffschichten kontinuierlich erzeugt werden, die gegebenenfalls nachträglich durch Pressen oder auch durch Kleben mit entsprechenden Schutz-, Reflexions- oder Absorberschichten sowie mit einem Substrat oder Träger verbunden werden können.

**Patentansprüche**

1. Verfahren zum Herstellen einer Leuchtstoffplatte, insbesondere einer Speicherleuchtstoffplatte, durch Warmverformung eines Rohlings bei einer Temperatur unterhalb der Schmelztemperatur, **dadurch gekennzeichnet,** daß der Rohling durch Walzen oder Extrudieren verformt wird.

2. Verfahren nach Anspruch 1, **dadurch gekennzeichnet,** daß die Leuchtstoffplatte mit einer optischen Absorptionsschicht versehen wird.

3. Verfahren nach Anspruch 1, **dadurch gekennzeichnet,** daß die Leuchtstoffplatte mit einer Reflexionsschicht versehen wird.

4. Verfahren nach Anspruch 1, **dadurch gekenn-**

**zeichnet,** daß die Leuchtstoffplatte mit einer Schutzschicht versehen wird.